# FASCICULE DE BREVET EUROPEEN

(11) **EP 0 362 008 B1**
(45) Date de publication et mention de la délivrance du brevet: **29.10.1997**
(21) Numéro de dépôt: 89402498.3
(22) Date de dépôt: 13.09.1989
(51) Int. Cl.: H03K 3/537

(54) **Générateur de Marx et ensemble d'éclateur dans un tel générateur**
Marx-Generator und Funkenstreckenanordnung in einem solchen Generator
Marx generator and spark gap assembly in such a generator

(30) Priorité: 28.09.1988 FR 8812661
(43) Date de publication de la demande: 04.04.1990
(73) Titulaire: AEROSPATIALE Société Nationale Industrielle, 75781 Paris Cédex 16 (FR)
(72) Inventeur: Lherm, André, F-33000 Le Haillan (FR); Raveu, Bernard, F-33160 Saint Medard en Jalles (FR)
(74) Mandataire: Bonnetat, Christian

(56) Documents cités:
- EP-A- 0 162 766
- EP-A- 0 313 439
- FR-A- 2 184 187
- US-A- 3 248 574
- US-A- 3 783 289
- JAPANESE JOURNAL OF APPLIED PHYSICS, vol. 20, no. 12, décembre 1981, pages 2397-2400,; Y. KUBOTA et al.: "Study of the rectangular-like output waveforms of a 720 kV coaxial Marx generator"
- INSTRUMENTS AND EXPERIMENTAL TECHNIQUES, vol. 19, no. 5, partie 1, septembre/ octobre 1976, pages 1375-1377; I.K. ZHANKOV: "High-speed voltage-pulse generator with local pressurization and mutual irradiation of spark gaps"

## Description

La présente invention concerne un générateur de Marx et un ensemble d'éclateur pour un tel générateur.

On sait qu'un générateur de Marx comporte plusieurs étages de condensateur qui sont chargés en parallèle et déchargés en série. Chaque étage de condensateur peut être chargé sous des tensions supérieures à plusieurs centaines de kilovolts, de sorte que la tension et l'énergie disponibles à la sortie dudit générateur peuvent respectivement atteindre quelques mégavolts et quelques dizaines de kilojoules.

Par exemple, dans EP-A-0 313 439 [qui fait partie de l'état de la technique au sens de l'article 54(3) CBE], il est décrit un générateur de Marx, comportant :
- une enveloppe étanche, à l'intérieur de laquelle règne une atmosphère d'un gaz diélectrique ;
- une pluralité d'étages de condensateur, en forme de tore, agencés dans ladite enveloppe, en étant montés coaxialement à un axe commun et en étant juxtaposés le long dudit axe ;
- chaque étage de condensateur présentant un condensateur, noyé dans un enrobage diélectrique, en forme de couronne, et relié, par une pluralité d'électrodes, à deux bornes annulaires, coaxiales audit axe ;
- lesdites bornes étant respectivement reliées à des têtes d'éclateur, logées dans l'évidement central des étages de condensateur, chaque étage de condensateur comportant deux têtes d'éclateur, dont l'une coopère avec une tête d'éclateur de l'étage précédent et l'autre coopère avec une tête d'éclateur de l'étage suivant pour former, à chaque fois, une paire de têtes d'éclateur associées.

Un tel générateur de Marx se révèle généralement satisfaisant à l'usage.

Toutefois, dans ce cas, chaque tête d'éclateur est solidaire de la borne correspondante de l'étage de condensateur auquel appartient ladite tête d'éclateur. Cela entraîne les inconvénients suivants.

En effet, le réglage de la position d'une tête d'éclateur se fait par rapport à une référence théorique (axe) de l'étage de condensateur auquel appartient ladite tête d'éclateur. Puis, deux étages adjacents, portant chacun deux demi-éclateurs, sont assemblés et les têtes d'éclateur respectives se trouvent alors en regard l'une de l'autre, sans qu'il soit possible d'intervenir aussi bien en ce qui concerne leur écartement qu'en ce qui concerne leur coaxialité.

Cependant, lors de l'assemblage, l'écartement et l'alignement des têtes peuvent varier aléatoirement s'il existe des jeux mécaniques, des dispersions de cote ou des contraintes de serrage et cela d'autant plus que le nombre de pièces en présence est grand.

Par ailleurs, les diverses forces dynamiques, mises en jeu lors du fonctionnement du générateur, peuvent entraîner des déplacements qui modifient la position et l'écartement des têtes d'éclateur.

Il se crée ainsi des variations des caractéristiques de déclenchement des générateurs de Marx du type indiqué ci-dessus, qui remettent en cause leur fiabilité de fonctionnement.

La présente invention a pour but d'éviter les inconvénients ci-dessus, et concerne un générateur de Marx dont la fiabilité, c'est-à-dire la constance des résultats des tirs, est améliorée.

A cet effet, le générateur de Marx, du type spécifié ci-dessus, est remarquable, selon l'invention, en ce que les têtes d'éclateur de chacune desdites paires de têtes d'éclateur associées sont montées sur un même support isolant, de façon à être liées mécaniquement l'une à l'autre.

Bien que lesdites paires de têtes d'éclateur associées puissent être, chacune, solidaires initialement d'un étage de condensateur, et reliées ensuite à l'étage voisin, il est avantageux que chacune desdites paires de têtes d'éclateur associées forme un bloc unitaire logé, de façon amovible, dans un évidement prévu à l'interface de deux étages consécutifs, ledit évidement pouvant être en particulier formé de deux moitiés d'évidement, ménagées respectivement dans l'un et l'autre desdits étages consécutifs.

Ainsi, chaque paire de têtes d'éclateur associées formant un bloc unitaire d'éclateur :
- est mécaniquement indépendante des deux étages de condensateur auxquels elle est associée,
- permet le réglage précis de l'écartement des têtes d'éclateur , avant sa fixation auxdits étages,
- assure l'alignement et la co-axialité des têtes d'éclateur,
- permet d'absorber les déformations dues aux forces dynamiques engendrées par les tirs, sans remettre en cause l'écartement des têtes d'éclateur .

Avantageusement, chaque paire de têtes d'éclateur associées comporte deux corps de tête d'éclateur disposés en regard l'un de l'autre, de part et d'autre, respectivement, de l'axe commun aux étages de condensateur et symétriquement par rapport audit axe.

De plus, chaque corps de tête d'éclateur peut être relié à l'électrode correspondante par une lame de connexion coudée, permettant le raccordement électrique de chaque corps de tête à l'étage auquel appartient ladite tête d'éclateur.

De préférence, ledit support isolant présente une forme de tore, dans l'évidement central duquel sont montés lesdits corps de tête.

En particulier, chaque corps de tête d'éclateur est muni d'une tige filetée, grâce à laquelle il peut être monté dans un alésage correspondant dudit support.

Avantageusement, ladite lame de connexion est serrée entre la base du corps de tête d'éclateur et la partie de surface correspondante de l'évidement central du support isolant.

De préférence, entre la base du corps de tête d'éclateur et ladite partie de surface correspondante de l'évidement central du support isolant, est prévue une cale de réglage de l'écartement des corps de tête.

La présente invention concerne également un ensemble d'éclateur, dans un générateur de Marx du type indiqué précédemment, remarquable, selon l'invention, en ce que ledit ensemble d'éclateur est constitué d'une paire de têtes d'éclateur associées, montées sur un même support isolant, de façon à être liées mécaniquement l'une à l'autre.

Avantageusement, ledit support isolant présente une forme de tore, dans l'évidement central duquel sont montés, en regard l'un de l'autre, les deux corps de tête respectifs de ladite paire de têtes d'éclateur associées, corps de tête destinés à être reliés, respectivement, à deux étages de condensateur adjacents dudit générateur.

La présente invention concerne de plus un procédé de montage d'un ensemble d'éclateur dans un générateur de Marx défini ci-dessus, ledit ensemble d'éclateur, formant un bloc unitaire, étant constitué de ladite paire de têtes d'éclateur, montées sur un même support isolant présentant une forme de tore, dans l'évidement central duquel sont agencés, en regard l'un de l'autre, les deux corps de tête respectifs de ladite paire de têtes d'éclateur, destinés à être reliés, respectivement, par une lame de connexion coudée, à deux étages de condensateur adjacents dudit générateur, procédé remarquable par les étapes suivantes :
- on règle préalablement l'écartement des corps de tête d'éclateur,
- un premier corps de tête est démonté, en libérant sa lame de connexion qui est montée sur la borne correspondante de l'étage de condensateur à équiper,
- on monte ensuite, dans l'évidement prévu à cet effet dudit étage, l'ensemble d'éclateur muni du second corps de tête,
- le premier corps de tête est alors remonté sur l'ensemble en pinçant la lame de connexion associée entre le corps de tête et le support,
- on monte ensuite l'étage de condensateur suivant, le support torique assurant son centrage sur l'ensemble d'éclateur, et
- on fixe la lame de connexion du second corps de tête sur la borne correspondante du dernier étage de condensateur monté.

Avantageusement, le premier corps de tête peut être freiné par injection de produit de blocage dans celui-ci.

Les figures du dessin annexé feront bien comprendre comment l'invention peut être réalisée. Sur ces figures, des références identiques désignent des éléments semblables.

La figure 1 est une coupe longitudinale schématique d'un générateur de Marx.

La figure 2 est une coupe diamétrale, à plus grande échelle, illustrant la structure d'un étage de condensateur et sa liaison aux étages voisins, dans un générateur de Marx connu.

La figure 3 est une vue de face d'un condensateur d'un tel étage, montrant la répartition des électrodes longues.

La figure 4 est une vue semblable à la figure 2, montrant des ensembles d'éclateur selon l'invention.

La figure 5 est une vue en coupe selon la ligne V-V de la figure 6.

La figure 6 est une vue de face d'un ensemble d'éclateur selon l'invention.

La figure 7 est une vue en coupe selon la ligne VII-VII de la figure 6.

La figure 8 est une vue de dessus d'une lame de connexion.

Les figures 9a à 9d illustrent les différentes étapes du procédé de montage d'un ensemble d'éclateur de l'invention dans un générateur de Marx.

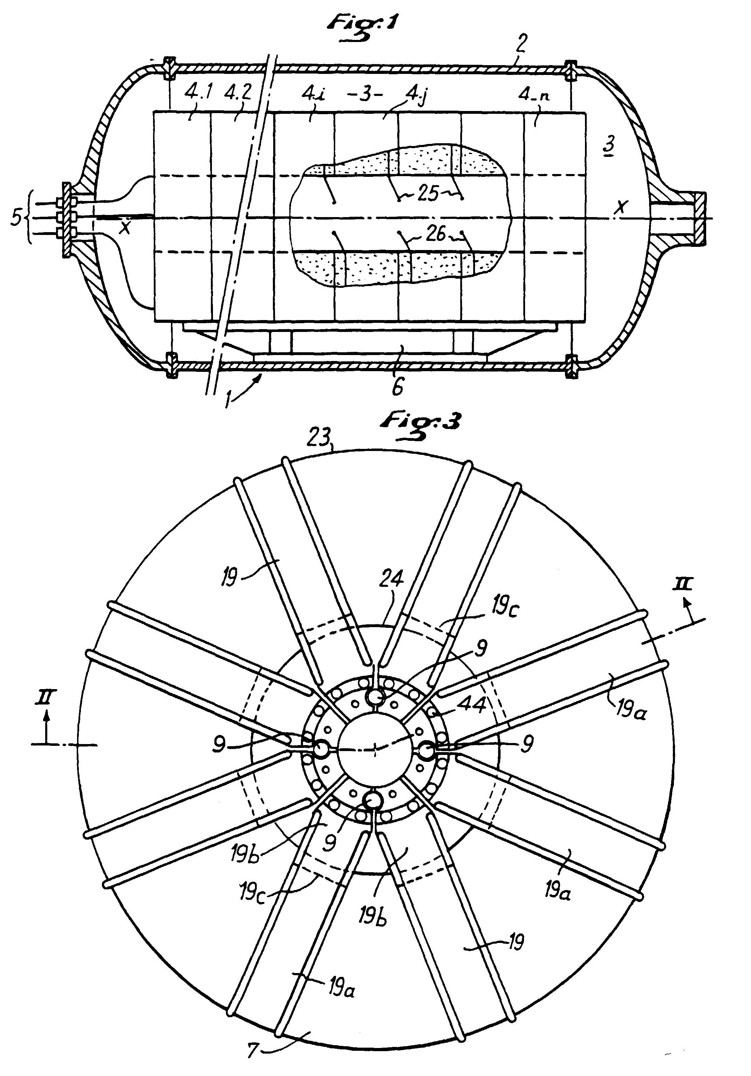

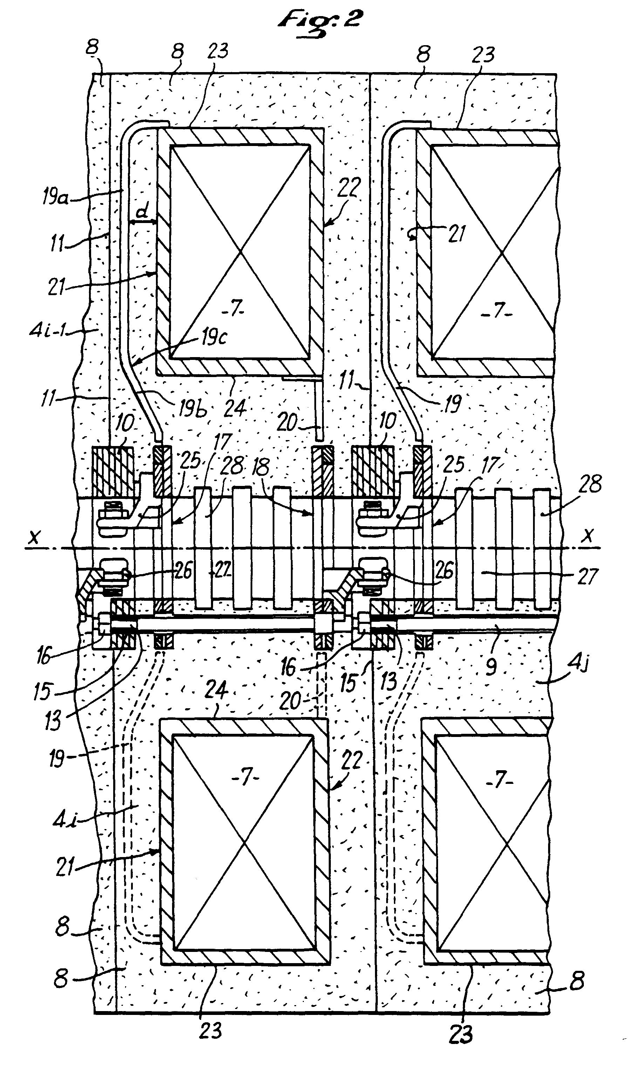

Le générateur de Marx 1, montré schématiquement sur la figure 1, comporte, de façon classique, une enveloppe étanche 2, à l'intérieur 3 de laquelle règne une atmosphère d'un gaz diélectrique, par exemple de l'hexafluorure de soufre SF6. Dans l'enveloppe 2, sont agencés une pluralité d'étages de condensateur 4.1, 4.2,...,4.i,4.j,...4.n, qui, comme on peut mieux le voir sur les figures 2 et 3, présentent chacun la forme d'un tore de section rectangulaire. Ces étages de condensateur sont tous montés coaxialement à un axe commun X-X et sont juxtaposés le long dudit axe. De façon connue et non représentée, lesdits étages de condensateur sont électriquement connectés les uns aux autres, notamment par l'intermédiaire de résistances non représentées, pour pouvoir être chargés en parallèle, puis déchargés en série. De plus, des connexions électriques 5 relient lesdits étages de condensateur à des dispositifs électriques de commande, non représentés, extérieurs a l'enveloppe 2.

Par ailleurs, les étages de condensateur 4.1 a 4.n, sont mécaniquement solidaires les uns des autres et leur ensemble est mécaniquement porté par un support ou plusieurs supports 6, les liant à l'enveloppe 2. Par exemple, l'axe commun X-X est horizontal et le support 6 forme un socle, qui supporte lesdits étages de condensateur et qui est lui-même supporté par ladite enveloppe 2.

Sur la figure 2, on a représenté, schématiquement en coupe axiale, l'un quelconque 4.i desdits étages de condensateur, ainsi que, partiellement, les étages de condensateur 4.i-1 et 4.j, qui sont respectivement disposés de part et d'autre dudit étage 4.i.

Comme on peut le voir, chaque étage de condensateur comporte un condensateur 7 en forme de couronne, centré sur l'axe X-X et noyé dans un enrobage de résine diélectrique 8.

Les enrobages 8 présentent eux-mêmes la forme d'une couronne coaxiale à l'axe X-X et comportent des faces d'extrémité 11, par lesquelles ils peuvent s'appuyer les uns contre les autres.

Les étages de condensateur consécutifs sont mécaniquement liés les uns aux autres grâce à des tirants de solidarisation 9, prenant appui sur des bagues de centrage 10. Chaque bague de centrage 10 s'ajuste dans des évidements centraux en regard prévus dans les faces d'extrémité et d'appui 11 des enrobages consécutifs 8. Chaque tirant 9 est pourvu a chacune de ses extrémités de filetages 13, qui, soit se vissent dans des taraudages desdites bagues 10, soit traversent librement des alésages 15 de celles-ci. Sur les filetages 13 se vissent des écrous de pression 16. Chaque bague 10 comporte des taraudages, et des alésages 15.

Sur la figure 2, on n'a pas représenté les liaisons électriques entre les étages de condensateur consécutifs. En revanche, on a représenté les bornes 17 et 18 de chaque étage de condensateur et les électrodes 19 et 20 correspondantes. De façon connue, les électrodes 19 et 20 sont constituées de bandes métalliques minces (par exemple quelques dixièmes de mm), généralement désignées sous le nom de clinquant.

Chaque borne 17 et 18 présente une forme annulaire et est disposée au voisinage de l'axe X-X, auquel elle est coaxiale. De plus, lesdites bornes 17 et 18 se trouvent chacune, respectivement et au moins approximativement, dans le plan des faces d'extrémité 21 ou 22 des condensateurs 7. Ainsi, l'encombrement axial de chaque étage peut être minimum.

La borne annulaire 17 de chaque étage est reliée, par une pluralité d'électrodes 19 radiales (voir la figure 3 sur laquelle on a supposé que l'enrobage 8 était éliminé), à la périphérie externe 23 du condensateur 7 correspondant. Les électrodes 19 sont donc longues. Elles comportent une partie plane allongée 19a, parallèle à la face d'extrémité 21 correspondante du condensateur 7 associé et écartée de celle-ci d'une distance d. Toutefois, pour rejoindre la borne annulaire 17, elle doit comporter de plus une partie centrale inclinée 19b, reliée à la partie plane 19a par un coude 19c, se trouvant au voisinage de la périphérie interne 24 dudit condensateur 7.

Par ailleurs, la borne annulaire 18 de chaque étage de condensateur est reliée, par une pluralité d'électrodes radiales 20 (dont la disposition en étoile n'est pas représentée mais est avantageusement semblable à celle des électrodes 19, telle que montrée sur la figure 3), à la périphérie interne 24 du condensateur 7 correspondant. Les électrodes 20 sont donc plus courtes que les électrodes 19. De plus, puisqu'elles sont logées à l'intérieur de ladite périphérie interne 24, elles peuvent être rectilignes sur toute leur longueur.

Les bornes 17 et 18 sont respectivement solidaires de têtes d'éclateur 25 ou 26, logées dans l'évidement central 27 des étages de condensateur et disposées de façon que la tête d'éclateur 25 d'un étage puisse coopérer avec la tête d'éclateur 26 de l'étage suivant, lesdites têtes d'éclateur 25 et 26 étant disposées en regard l'une de l'autre.

Par ailleurs, des gorges 28 peuvent être pratiquées dans la paroi dudit évidement central 27 afin d'éliminer la conduction électrique par effet de peau.

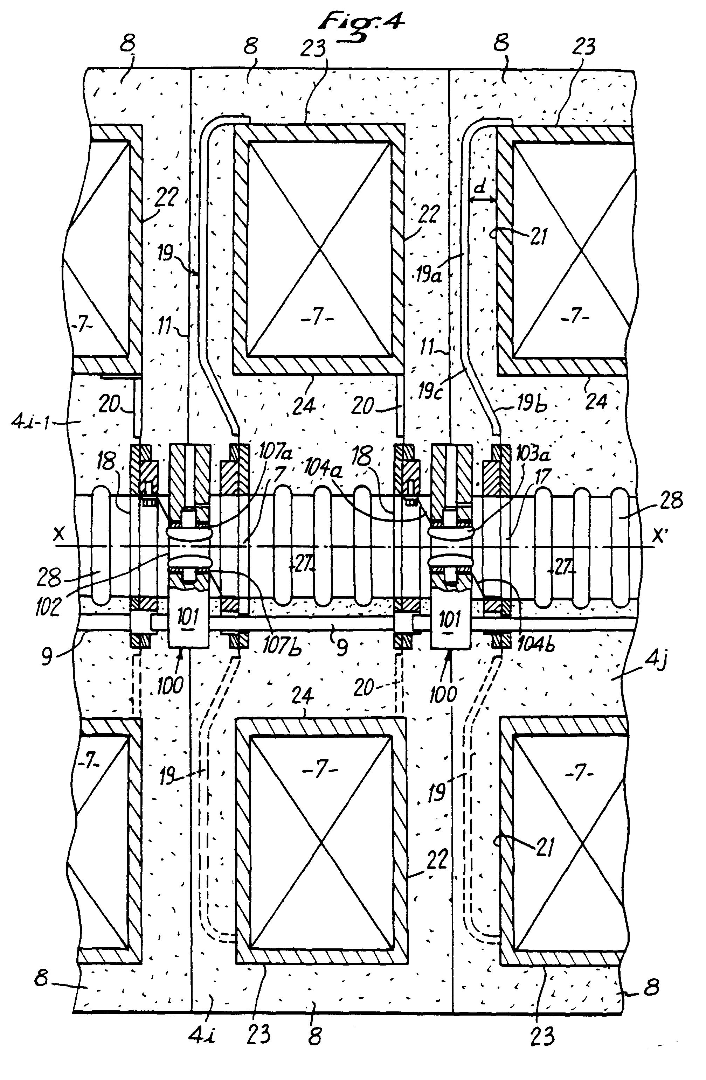

Comme on peut le constater en comparant les figures 2 et 4, le générateur de Marx de l'invention (figure 4) se distingue du générateur de Marx connu (figure 2) par l'agencement de chaque paire de têtes d'éclateur associées en un bloc unitaire 100, mécaniquement indépendant des étages de condensateur correspondants. On ne reprendra pas ici la description des parties identiques à celles du générateur de la figure 2, désignées, sur la figure 4, par les mêmes références.

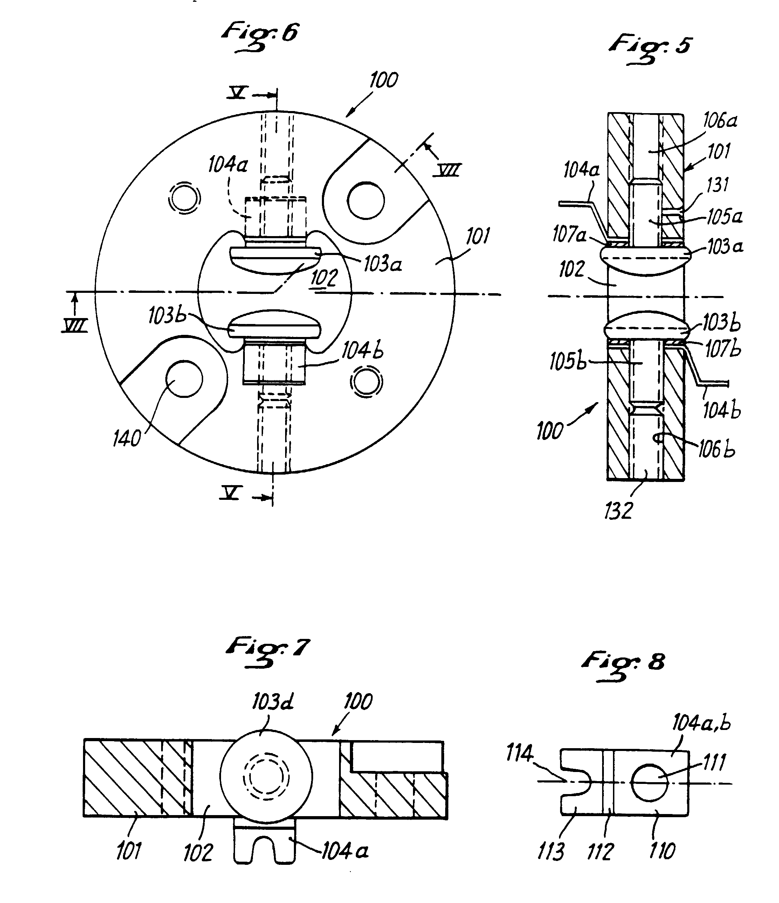

Comme on peut mieux le voir sur les figures 5 à 8, un ensemble d'éclateur 100 comporte un support isolant en forme de tore 101, dans l'évidement central 102 duquel sont montés, en regard l'un de l'autre, les deux corps de tête respectifs 103a et 103b de la paire de têtes d'éclateur associées, corps de tête destinés à être reliés, respectivement, à deux étages de condensateur adjacents du générateur, par des lames de connexion électrique coudées 104a et 104b. De plus, chaque corps de tête d'éclateur 103a,103b est muni d'une tige filetée 105a,105b, grâce à laquelle il peut être monté, de façon amovible, dans un alésage 106a,106b correspondant du support 101. On peut prévoir soit un canal 131 d'injection de produit de blocage dans l'alésage, soit une vis de blocage 132.

Par ailleurs, entre la base de chaque corps de tête d'éclateur 103a,103b et la partie de surface correspondante de l'évidement central 102 du support isolant 101, est prévue une cale 107a,107b de réglage de l'écartement des corps de tête 103a,103b.

Chaque lame de connexion 104a,104b comporte une première partie plane 110 munie d'un trou 111 pour le passage de la tige filetée 105a,105b, une partie centrale inclinée 112, et une seconde partie plane 113, parallèle à la première 110, munie d'un évidement 113 pour la fixation de la lame à l'électrode 17,18 correspondante (figure 8).

Les lames de connexion doivent être suffisamment souples pour permettre leur fixation mécanique en tenant compte des tolérances de fabrication des différentes pièces en présence, et suffisamment rigides pour garantir une géométrie après montage permettant de répondre aux phénomènes de champs magnétiques déjà évoqués dans EP-A-0 313 439, cité ci-dessus. A cet effet, ces lames de connexion sont réalisées en matériau métallique bon conducteur de l'électricité sous forme de clinquant plié aux dimensions requises selon des techniques connues.

Les figures 9a à 9d illustrent les différentes étapes du procédé de montage d'un ensemble d'éclateur selon l'invention entre deux étages de condensateur du générateur de Marx montré sur la figure 4.

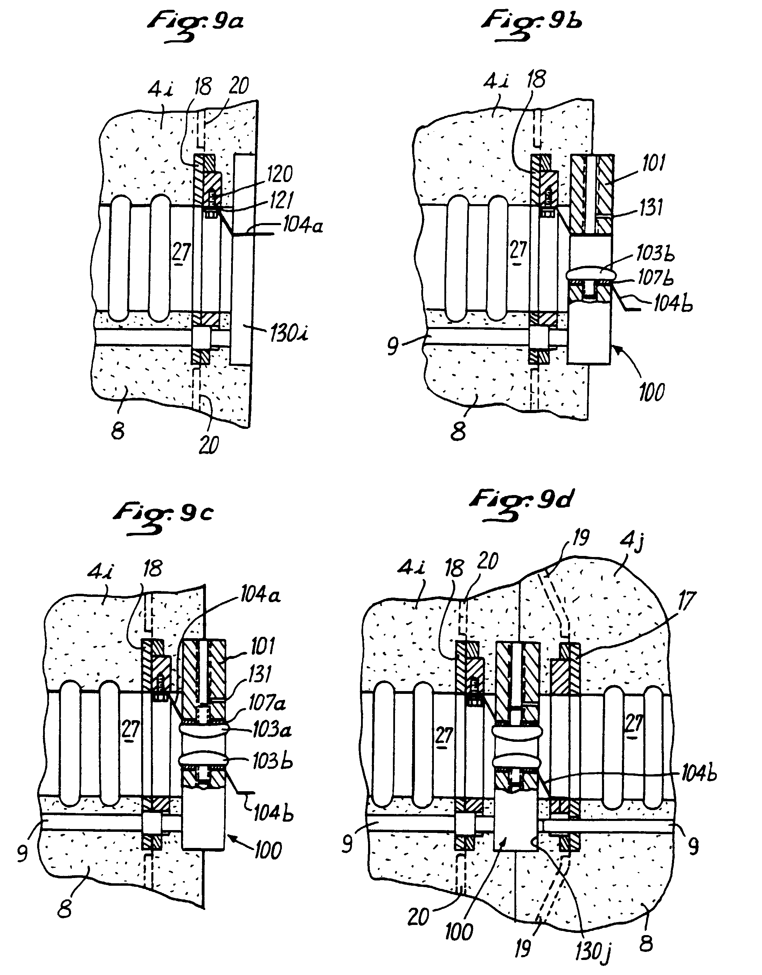

L'ensemble d'éclateur 100, tel que représenté sur les figures 5 à 7, est préalablement réglé en ce qui concerne l'écartement des corps de tête 103a,103b en jouant sur l'épaisseur des cales 107a,107b. Puis, un premier corps de tête 103a de l'ensemble d'éclateur est démonté, avec sa cale 107a, en libérant ainsi la lame de connexion 104a correspondante, qui peut être montée sur la borne 18 de l'étage 4i en y étant fixée à l'aide d'une vis 120 et d'une rondelle 121 (figure 9a). Ensuite, l'ensemble d'éclateur 100, équipé du second corps de tête 103b, avec sa cale 107b et sa lame de connexion 104b, est monté dans l'évidement 130i prévu à cet effet de l'étage 4i et y est fixé à l'aide des tirants 9 (figure 9b) traversant les alésages 140. Alors, le premier corps de tête 103a et sa cale 107a peuvent être remontés sur l'ensemble 100 en pinçant la lame de connexion 104a correspondante entre la cale 107a et la partie de surface correspondante de l'évidement central du support isolant 101, le freinage du premier corps de tête 103a pouvant être obtenu par injection de produit de blocage dans le canal 131 (figure 9c). On monte ensuite l'étage de condensateur suivant 4j, le support torique 101 assurant son centrage sur l'ensemble d'éclateur 100, et on l'y fixe à l'aide des tirants 9. Le support torique 101 joue ainsi le rôle de la pièce de centrage 10 dans le générateur de Marx connu de la figure 2 et se loge dans l'évidement 130j de forme correspondante de l'étage 4j. Enfin, on fixe la lame de connexion 104b du second corps de tête 103b sur la borne corespondante 17 de l'étage 4j (figure 9d).

Ainsi, l'écartement de corps de tête d'éclateur 103a,103b est celui défini par réglage préalable, à l'aide des cales 107a,107b, et la liaison électrique de chaque corps de tête 103a,103b avec l'étage de condensateur 4i,4j correspondant est réalisée par les lames de connexion 104a,104b.

## Revendications

1. Générateur de Marx, comportant :
- une enveloppe étanche, à l'intérieur de laquelle règne une atmosphère d'un gaz diélectrique ;
- une pluralité d'étages de condensateur, en forme de tore, agencés dans ladite enveloppe, en étant montés coaxialement à un axe commun et en étant juxtaposés le long dudit axe ;
- chaque étage de condensateur présentant un condensateur, noyé dans un enrobage diélectrique, en forme de couronne, et relié, par une pluralité d'électrodes, à deux bornes annulaires, coaxiales audit axe ;
- lesdites bornes étant respectivement reliées à des têtes d'éclateur, logées dans l'évidement central des étages de condensateur, chaque étage de condensateur comportant deux têtes d'éclateur, dont l'une coopère avec une tête d'éclateur de l'étage précédent et l'autre coopère avec une tête d'éclateur de l'étage suivant pour former, à chaque fois, une paire de têtes d'éclateur associées ; et
- les têtes d'éclateurs de chacune desdites paires (100) de têtes d'éclateurs associées étant montées sur un même support isolant (101), de façon à être liées mécaniquement l'une à l'autre.

2. Générateur de Marx selon la revendication 1,
caractérisé en ce que chacune desdites paires de têtes d'éclateur associées forme un bloc unitaire (100) logé, de façon amovible, dans un évidement (130i,130j) prévu à l'interface de deux étages consécutifs (4i,4j).

3. Générateur de Marx selon la revendication 2,
caractérisé en ce que ledit évidement est formé de deux moitiés (130i,130j) d'évidement, ménagées respectivement dans l'un et l'autre desdits étages consécutifs (4i,4j).

4. Générateur de Marx selon l'une quelconque des revendications 1 à 3,
caractérisé en ce que chaque paire (100) de têtes d'éclateur associées comporte deux corps de tête (103a,103b) d'éclateur disposés en regard l'un de l'autre, de part et d'autre, respectivement, de l'axe commun (X,X') aux étages de condensateur et symétriquement par rapport audit axe.

5. Générateur de Marx selon la revendication 4,
caractérisé en ce que chaque corps de tête (103a,103b) d'éclateur est relié à l'électrode (20,19) correspondante par une lame de connexion coudée (104a,104b).

6. Générateur de Marx selon la revendication 4 ou la revendication 5,
caractérisé en ce que ledit support isolant présente une forme de tore (101), dans l'évidement central (102) duquel sont montés lesdits corps de tête (103a,103b).

7. Générateur de Marx selon la revendication 6,
caractérisé en ce que chaque corps de tête (103a,103b) d'éclateur est muni d'une tige filetée (105a,105b), grâce à laquelle il peut être monté dans un alésage (106a,106b) correspondant dudit support (101).

8. Générateur de Marx selon la revendication 6 ou la revendication 7,
caractérisé en ce que ladite lame de connexion (104a,104b) est serrée entre la base du corps de tête d'éclateur (103a, 103b) et la partie de surface correspondante de l'évidement central (102) du support isolant (101).

9. Générateur de Marx selon la revendication 8,
caractérisé en ce que, entre la base du corps de tête d'éclateur (103a,103b) et ladite partie de surface correspondante de l'évidement central (102) du support isolant (101), est prévue une cale de réglage (107a,107b) de l'écartement des corps de tête (103a, 103b).

10. Ensemble d'éclateur (100), dans un générateur de Marx comportant :
- une enveloppe étanche, à l'intérieur de laquelle règne une atmosphère d'un gaz diélectrique ;
- une pluralité d'étages de condensateur, en forme de tore, agencés dans ladite enveloppe, en étant montés coaxialement à un axe commun et en étant juxtaposés le long dudit axe ;
- chaque étage de condensateur présentant un condensateur, noyé dans un enrobage diélectrique, en forme de couronne, et relié, par une pluralité d'électrodes, à deux bornes annulaires, coaxiales audit axe ;
- lesdites bornes étant respectivement reliées à des têtes d'éclateur, logées dans l'évidement central des étages de condensateur, chaque étage de condensateur comportant deux têtes d'éclateur, dont l'une coopère avec une tête d'éclateur de l'étage précédent et l'autre coopère avec une tête d'éclateur de l'étage suivant pour former, à chaque fois, une paire de têtes d'éclateur associées,
caractérisé en ce que ledit ensemble d'éclateur est constitué de ladite paire de têtes d'éclateur associées, montées sur un même support isolant (101), de façon à être liées mécaniquement l'une à l'autre.

11. Ensemble d'éclateur selon la revendication 10,
caractérisé en ce que ledit support isolant (101) présente une forme de tore, dans l'évidement central (102) duquel sont montés, en regard l'un de l'autre, les deux corps de tête (103a,103b) respectifs de ladite paire de têtes d'éclateur associées, corps de tête destinés à être reliés, respectivement, à deux étages de condensateur adjacents (4i,4j) dudit générateur.

12. Ensemble d'éclateur selon la revendication 11,
caractérisé en ce que chaque corps de tête d'éclateur (103a,103b) est muni d'une tige filetée (105a,105b), grâce à laquelle il peut être monté dans un alésage (106,106b) correspondant dudit support (101).

## Patentansprüche

1. Marx-Generator mit:
- einem dichten Mantel, in dem eine Atmosphäre eines dielektrischen Gases herrscht;
- mehreren ringförmigen Kondensatorstufen in diesem Mantel, die koaxial zu einer gemeinsamen Achse längs dieser Achse angeordnet sind; wobei
- jede Kondensatorstufe einen kranzförmigen Kondensator in einer dielektrischen Einbettung hat, der über mehrere Elektroden mit zwei ringförmigen, zur Achse koaxialen Klemmen verbunden ist;
- die Klemmen jeweils mit Funkenstreckenköpfen verbunden sind, die in der mittleren Aussparung der Kondensatorstufen gelagert sind und jede Kondensatorstufe zwei Funkenstreckenköpfe hat, von denen einer mit einem Funkenstreckenkopf der vorangehenden Stufe und der andere mit einem Funkenstreckenkopf der folgenden Stufe zusammenwirkt, so daß jeweils ein Paar zugeordneter Funkenstreckenköpfe entsteht; und
- die Funkenstreckenköpfe jedes Paars (100) einander zugeordneter Funkenstreckenköpfe auf der gleichen Isolierunterlage (101) angebracht werden, so daß sie mechanisch miteinander verbunden sind.

2. Marx-Generator nach Anspruch 1,
dadurch gekennzeichnet, daß jedes Paar einander zugeordneter Funkenstreckenköpfe einen einheitlichen Block (100) bildet, der lösbar in einer Aussparung (130i,130j) an der Grenzfläche von zwei aufeinanderfolgenden Stufen (4i,4j) gelagert ist.

3. Marx-Generator nach Anspruch 2,
dadurch gekennzeichnet, daß die Aussparung aus zwei Aussparungshälften (130i,130j) jeweils in der einen und der anderen der aufeinanderfolgenden Stufen (4i,4j) angeordnet ist.

4. Marx-Generator nach einem der Ansprüche 1 bis 3,
dadurch gekennzeichnet, daß jedes Paar (100) einander zugeordneter Funkenstreckenköpfe zwei Funkenstreckenkopfgehäuse (103a,103b) hat, die einander gegenüber, jeweils beiderseits der gemeinsamen Achse (X,X') der Kondensatorstufen symmetrisch zu dieser Achse angeordnet sind.

5. Marx-Generator nach Anspruch 4,
dadurch gekennzeichnet, daß jedes Funkenstreckenkopfgehäuse (103a,103b) mit der entsprechenden Elektrode (20,19) durch einen abgewinkelten Anschlußstreifen (104a,104b) verbunden ist.

6. Marx-Generator nach Anspruch 4 oder Anspruch 5,
dadurch gekennzeichnet, daß die Isolierunterlage die Form eines Ringes (101) hat, in dessen mittlerer Aussparung (102) die Kopfgehäuse (103a,103b) angeordnet sind.

7. Marx-Generator nach Anspruch 6,
dadurch gekennzeichnet, daß jedes Funkenstreckenkopfgehäuse (103a,103b) mit einer Gewindestange (105a,105b) versehen ist, durch die es in einer entsprechenden Bohrung (106a,106b) der Unterlage (101) angebracht werden kann.

8. Marx-Generator nach Anspruch 6 oder Anspruch 7,
dadurch gekennzeichnet, daß der Anschlußstreifen (104a,104b) zwischen der Grundfläche des Funkenstreckenkopfgehäuses (103a,103b) und dem entsprechenden Oberflächenteil der mittleren Aussparung (102) der Isolierunterlage (101) geklemmt wird.

9. Marx-Generator nach Anspruch 8,
dadurch gekennzeichnet, daß zwischen der Grundfläche des Funkenstreckenkopfgehäuses (103a,103b) und dem entsprechenden Oberflächenteil der mittleren Aussparung (102) der Isolierunterlage (101) eine Zwischenscheibe (107a,107b) zur Einstellung des Abstands der Kopfgehäuse (103a,103b) vorgesehen ist.

10. Funkenstreckenanordnung (100) in einem Marx-Generator mit:
- einem dichten Mantel, in dem eine Atmosphäre eines dielektrischen Gases herrscht;
- mehreren ringförmigen Kondensatorstufen, die im Mantel koaxial zu einer gemeinsamen Achse längs dieser Achse angebracht sind; wobei
- jede Kondensatorstufe einen kranzförmigen Kondensator hat, der in ein Dielektrikum eingebettet ist und über mehrere Elektroden mit zwei ringförmigen, zu dieser Achse koaxialen Klemmen verbunden ist;
- die Klemmen jeweils mit Funkenstreckenköpfen in der mittleren Aussparung der Kondensatorstufen verbunden sind, wobei jede Kondensatorstufe zwei Funkenstreckenköpfe hat, von denen einer mit einem Funkenstreckenkopf der vorangehenden Stufe und der andere mit einem Funkenstreckenkopf der folgenden Stufe zusammenwirkt, so daß jeweils ein Paar einander zugeordneter Funkenstreckenköpfe gebildet wird,
dadurch gekennzeichnet, daß die Funkenstreckenanordnung aus dem Paar einander zugeordneter Funkenstreckenköpfe besteht, die auf der gleichen Isolierunterlage (101) angeordnet und damit mechanisch miteinander verbunden sind.

11. Funkenstreckenanordnung nach Anspruch 10,
dadurch gekennzeichnet, daß die Isolierunterlage (101) die Form eines Ringes hat, in dessen mittlerer Aussparung (102) einander gegenüber die beiden jeweiligen Kopfgehäuse (103a,103b) des Paars einander zugeordneter Funkenstreckenköpfe angeordnet sind, die jeweils mit zwei benachbarten Kondensatorstufen (4i,4j) des Generators verbunden werden sollen.

12. Funkenstreckenanordnung nach Anspruch 11,
dadurch gekennzeichnet, daß jedes Funkenstreckenkopfgehäuse (103a,103b) mit einer Gewindestange (105a,105b) versehen ist, durch die es in einer entsprechenden Bohrung (106,106b) der Unterlage (101) angebracht werden kann.

## Claims

1. Impulse generator including:
- a sealed enclosure containing a dielectric gas atmosphere;
- a plurality of toroidal capacitor stages within said enclosure mounted coaxially with a common axis and juxtaposed along said axis;
- each capacitor stage comprising an annular capacitor embedded in a dielectric coating and connected by a plurality of electrodes to two annular terminals coaxial with said axis;
- said terminals being respectively connected to discharger heads housed in the central opening of the capacitor stages, each capacitor stage including two discharger heads, one of which cooperates with a discharger head of the preceding stage and the other of which cooperates with a discharger head of the next stage to form, on each occasion, a pair of associated discharger heads; and
- the discharger heads of each of said pairs (100) of associated discharger heads being mounted on a common insulative support (101) so that they are mechanically coupled to each other.

2. Impulse generator according to claim 1 characterised in that each of said pairs of associated discharger heads forms a unitary assembly (100) that is removably housed in an opening (130i, 130j) provided at the interface between two consecutive stages (4i, 4j).

3. Impulse generator according to claim 2 characterised in that said opening is formed of two half-openings (130i, 130j) formed in respective consecutive stages (4i, 4j).

4. Impulse generator according to any one of claims 1 to 3 characterised in that each pair (100) of associated discharger heads includes two discharger head bodies (103a, 103b) facing each other on respective opposite sides of the axis (X, X') common to the capacitor stages and symmetrically about said axis.

5. Impulse generator according to claim 4 characterised in that each discharger head body (103a, 103b) can be connected to the corresponding electrode (20, 19) by a bent connection blade member (104a, 104b).

6. Impulse generator according to claim 4 or claim 5 characterised in that said insulative support has a toroidal shape (101) with said head bodies (103a, 103b) mounted in its central opening (102).

7. Impulse generator according to claim 6 characterised in that each discharger head body (103a, 103b) is provided with a screwthreaded rod (105a, 105b) by means of which it may be mounted in a corresponding bore (106a, 106b) of said support (101).

8. Impulse generator according to claim 6 or claim 7 characterised in that said connection blade member (104a, 104b) is clamped between the base of the discharger head body (103a, 103b) and the corresponding surface part of the central opening (102) in the insulative support (101).

9. Impulse generator according to claim 8 characterised in that a shim (107a, 107b) for adjusting the separation of the head bodies (103a, 103b) is provided between the base of the discharger head body (103a, 103b) and said corresponding surface part of the central opening (102) in the insulative support (101).

10. Discharger system (100) in an impulse generator including:
- a sealed enclosure containing a dielectric gas atmosphere;
- a plurality of toroidal capacitor stages within said enclosure mounted coaxially with a common axis and juxtaposed along said axis;
- each capacitor stage comprising an annular capacitor embedded in a dielectric coating and connected by a plurality of electrodes to two annular terminals coaxial with said axis;
- said terminals being respectively connected to discharger heads housed in the central opening of the capacitor stages, each capacitor stage including two discharger heads, one of which cooperates with a discharger head of the preceding stage and the other of which cooperates with a discharger head of the next stage to form, on each occasion, a pair of associated discharger heads,
characterised in that said discharger system is made up of a pair of associated discharger heads mounted on a common insulative support (101) so as to be mechanically coupled to each other.

11. Discharger system according to claim 10 characterised in that said insulative support (101) is toroidal shape with the respective two head bodies (103a, 103b) of said pair of associated discharger heads mounted in its central opening (102), facing each other, these head bodies being adapted to be connected to two respective adjacent capacitor stages (4i, 4j) of said generator.

12. Discharger system according to claim 11 characterised in that each discharger head body (103a, 103b) has a screwthreaded rod (105a, 105b) by means of which it can be mounted in a corresponding bore (106, 106b) in said support (101).
